# EUROPEAN PATENT SPECIFICATION

(11) **EP 2 875 525 B1**
(45) Date of publication and mention of the grant of the patent: **28.04.2021**
(21) Application number: 13739239.5
(22) Date of filing: 19.07.2013
(51) Int. Cl.: H01L 21/768, H01L 23/14, H01L 23/48, H01L 23/498

(54) **Semiconductor die with a through-silicon via and corresponding method of fabrication**
HALBLEITERCHIP MIT DURCHKONTAKTIERUNG UND zugehörige HERSTELLUNGSMETHODE
PUCE DE SEMI-CONDUCTEUR avec INTERCONNEXION verticale TRAVERSANTe ET PROCÉDÉ DE FABRICATION correspondant

(30) Priority: 19.07.2012 EP 12305874
(43) Date of publication of application: 27.05.2015
(73) Proprietor: Murata Integrated Passive Solutions, 14000 Caen (FR)
(72) Inventor: TENAILLEAU, Jean-René, F-14250 Hottot-les-Bagues (FR); VOIRON, Frédéric, F-38530 Barraux (FR)
(74) Representative: Cabinet Beau de Loménie
(86) International application number: PCT/EP2013/065354
(87) International publication number: WO 2014/013078

(56) References cited:
- EP-A2- 1 071 126
- WO-A1-2005/088699
- WO-A1-2009/104132
- WO-A2-2011/057238
- US-A1- 2002 115 260
- US-A1- 2012 061 795
- US-B1- 6 534 855

## Description

The present invention concerns a semiconductor die with a through silicon via and a manufacturing process of such a die.

The invention generally relates to integrated circuits (ICs) and more specifically to three-dimensional (3D) integration techniques in which multiple layers of ICs are stacked.

3D integration of circuits or packages is a known concept which can significantly reduce the size of an electronic system and also its cost. It allows therefore increasing density of integration of functions in ICs.

ICs may have integrated components arranged on one side of a silicon die. For systems having a three dimensional architecture, it is usual to have a layer, or interposer, comprising at least a via arranged to interconnect two ICs and contacts may be provided on both sides of interposer. Such vias permit the routing of signals between the various layers of the structure.

In a multilayer structure in which dies are stacked and in which one of them is e.g. an interposer, different functions required by the stacked system (like for example memory or processor) can be, at least partially, embedded onto the interposer. With this integration scheme, there can be differentiated:
- a first kind of interposer made from an active or passive integrated circuit, in which all the components are embedded on one side (only) of the interposer that is then assembled on a board by a so called "Double Flip Chip" process, and
- a second kind of interposer made from an active or passive integrated circuit, in which the components are embedded on two opposite sides of the interposer and are electrically intra-connected by means of "Through Silicon Vias" (or TSVs). Such interposers use a semiconductor substrate as bulk material for the implementation of the TSV(s).

The invention concerns more specifically but not exclusively this second kind of interposers.

When a via is implemented in a silicon substrate, it is desirable to electrically isolate it from the substrate. The insulation of the via concerns DC (direct current) insulation and also AC (alternative current) insulation.

The DC insulation of a via may be realised by coating the inner wall of the via with a dielectric layer. After this first insulation, the via is then coated with a stack of metallic layers comprising at least a barrier layer and a conductive layer. The barrier layer is for example a ruthenium or a tungsten nitride or a titanium nitride layer or a titanium (or another metallic material) layer or a combination of above. The conductive layer can be realised by a process such for example PVD (Physical Vapor Deposition) or MOCVD (Metal Organic Chemical Vapour Deposition) or ECD (Electrochemical Deposition) or electro-greffage. A conductive layer realised by an ECD process can also comprise the combination of a seed layer made of ruthenium or titanium coated with a copper deposited by PVD or MOCVD and with a thick copper layer grown by ECD.

The AC insulation permits the reduction of the coupling between the via and the surrounding material, namely the silicon, when for example a radio frequency (RF) signal is transmitted through the via. This coupling is mostly capacitive for signals conducted through the via and propagates through the parasitic capacitor formed by the inner-conductive layer forming a first electrode of this parasitic capacitor and the bulk silicon forming the second electrode of this capacitor. This coupling is responsible for energy losses. If there are more than one via, the coupling may also result in a crosstalk between adjacent vias.

WO2011/057238 describes a capacitor in a semiconductor substrate, employing a through silicon via. The conductive core of the via constitutes a first electrode of the capacitor and a tubular, doped semiconductor region surrounding the conductive core serves as a second electrode. A dielectric is interposed between the conductive core of the via and the tubular doped semiconductor region. To form the doped semiconductor region, arsenosilicate glass is deposited on the walls of the via and an annealing process derives dopants into the surrounding semiconductor substrate. The glass is subsequently removed.

WO2005/088699 describes a technique for fabricating a trench capacitor in a semiconductor substrate and vertical interconnects extending through the substrate. The substrate is etched from a first side to form the trenches for the trench capacitor as well as a portion of the holes for the vertical interconnect. Etching from the other side of the substrate then completes the formation of the holes for the vertical interconnects. The holes for the vertical interconnects are coated with a dielectric then filled with a conductive material.

WO2009/104132 describes another technique for fabricating a trench capacitor in a semiconductor substrate and vertical interconnects extending through the substrate. The substrate is etched from a first side to form the trenches for the trench capacitor as well as through-holes for the vertical interconnects. Boron glass is deposited over the exposed surfaces and dopants are driven into the walls of the through-holes and the walls of the trenches, to form a doped semiconductor layer. A dielectric is deposited over the doped semiconductor layer and then polysilicon is filled into the through-holes and trenches.

US-7,989,915 discloses a vertical electrical device that includes a region in a substrate extending from a surface of the substrate, the region having an inner wall and an outer wall circumscribing the inner wall. An inner electrically conductive layer is disposed on the inner wall and an outer electrically conductive layer is disposed on the outer wall, with an electrically insulative material disposed between the inner and outer layers. An electrical conductor in the substrate is bounded by the inner electrically conductive layer.

WO-2010/144467 shows a semiconductor die, having a substrate and including a through silicon via. The through silicon via includes a decoupling capacitor having a first co-axial conductor, a second co-axial conductor and a co-axial dielectric separating the first co-axial conductor from the second co-axial conductor. The decoupling capacitor is configured to provide local charge storage for components on the semiconductor die.

WO-2011/056374 discloses a through-silicon via (TSV) structure forming a unique co-axial or tri-axial interconnect within a silicon substrate. The TSV structure is provided with two or more independent electrical conductors insulated from another and from the substrate. The electrical conductors can be connected to different voltages or ground, making it possible to operate the TSV structure as a co-axial or tri-axial device. Multiple layers using various insulator materials can be used as insulator, wherein the layers are selected based on dielectric properties, fill properties, interfacial adhesion, CTE match, and the like. The TSV structure overcomes defects in the outer insulation layer that may lead to leakage. A method of fabricating such a TSV structure is also described in this document.

US-2012/0061795 discloses a device including a semiconductor substrate of a first conductivity type, wherein the semiconductor substrate comprises a first surface and a second surface opposite the first surface. A through-substrate via (TSV) extends from the first surface to the second surface of the semiconductor substrate. A well region of a second conductivity type opposite the first conductivity type encircles the TSV, and extends from the first surface to the second surface of the semiconductor substrate. The overall performance of the described device is limited.

US-2002115260 discloses various coaxial TSV configurations.

It is an object of the invention to provide a structure of a via which ensures a good insulation between itself and the surrounding bulk material. The invention concerns both, direct current insulation and alternative current insulation.

It is another object of the invention to provide a via with a very low resistivity. The invention can advantageously be applied also for via having a great aspect ratio (i.e. the ratio between its depth and its diameter).

It is another object of the invention to provide a new via which allows having co-axial or tri-axial via structure with an outer grounded shielding conductive layer. Preferably, the characteristic impedance of a such via will be able to be adjusted in view of limiting reflexion at the ends of the via.

To this end, the invention proposes a semiconductor die comprising a via realised in a bulk material, the via having an inner metallic conductor isolated from a surrounding conductive area by a first dielectric layer and a second dielectric layer, wherein the bulk material is chosen in a set of doped semiconductor materials containing p-type materials, wherein the surrounding conductive area is in contact with the bulk material, and wherein the surrounding conductive area is made from a material chosen in a set of doped semiconductor materials containing n-type materials.

According to the invention, the surrounding conductive area is formed by a diffused doped layer, the bulk material is doped silicon and the surrounding conductive area is doped with phosphorus, the concentration of dopants being more than 10¹⁵ atoms per cubic centimetre (>E15 a.cm⁻³). Moreover, the semiconductor die further comprises a third conductive layer formed by a polysilicon layer, this polysilicon layer is between the inner metallic conductor and the conductive area, and the polysilicon layer is isolated from the conductive area by the first dielectric layer and from the inner metallic conductor by the second dielectric layer.

In this new and original structure, the achieved via is surrounded by a conductive area obtained by diffusion of an opposite type dopant specie compared to the substrate, thus forming a PN junction with the substrate, this junction realising a very good shielding of the via. The diffused doped layer allows to improve the performance of the device. It allows to control a very uniform concentration of the dopant from the top to the bottom of the hole independently from the profile of the hole especially when this one has overhanging topology resulting from the deep etching process: tapered wall or scalloping. It allows also to reach high dopant concentrations thereby reducing capacitance to substrate and serial resistance. The performance of the device can thereby be increased.

The diffused doped layer can be obtained by the deposition of a doped glass followed by a diffusion step forming a doped area (preferably a highly doped area) and subsequent etch of the glass.

The second dielectric layer between the inner metallic conductor and the polysilicon layer preferably is an oxide layer.

The inner metallic conductor is for example in copper and its thickness is preferably at least 0.5 µm.

In a semiconductor die according to the invention, the dielectric layers can be made in materials chosen in the set of materials comprising silicon oxide, silicon nitride, low permittivity Silicon Oxycarbide and low permittivity polymers.

A via of a semiconductor die according the invention can have a co-axial or tri-axial structure with an outer grounded shielding conductive layer. The characteristic impedance of a such via can be adjusted by DC biasing the diode with a proper biasing structure (like a DC bias fed through a large inductance), such that the diode reverse capacitance is adjusted to the value ensuring best matching. The capacitance can also be minimized to prevent substrate coupling and thus power loss to the ground. In other word, the through silicon via can be used here as a tunable low pass filter. This is particularly useful in applications like medical implantable appliance where low frequency biological signals are to be measured while all HF/RF (i.e. high frequency or radio frequency) signals are to be rejected to ground (for example 64 MHz MRI signals -i.e. Magnetic Resonance Imaging signals-).

The invention provides a new via which uses a tubular diode cathode (N type doping) to propagate a signal, for example an RF signal, and the anode (P type doping) is left floating. In this particular configuration, when another cathode -belonging to a neighbouring via- is connected to the ground (GND), one obtained a back-to-back tubular diode structure that is natively self-protecting the signal vias against electrostatic discharge. The ratio signal/GND vias can be adjusted to optimize the performance of the electrostatic discharge (ESD) protection structure, i.e. reduction of resistance to the ground. This is particularly useful when the via is used for connecting ESD sensitive appliances.

In a semiconductor die according to the invention, the realized tubular diode has an advantageous junction surface compared to its footprint. Therefore the tubular diode allows local extraction of higher energy density compared to conventional surface diode components having similar footprint.

A semiconductor die according to the invention comprises also advantageously at least one trench capacity. The corresponding trenches and capacities can be realised at the same time as the via. Each trench capacity can comprise a conductive layer (lower electrode) having the same characteristics as the surrounding conductive area and a polysilicon layer (upper electrode) having the same characteristics as the polysilicon layer on top of the first dielectric layer and the surrounding conductive area.

The invention can advantageously be involved with a semiconductor die with a via having an aspect ratio greater than 20 and preferably greater than 25.

The invention also concerns a multilayer structure comprising an interposer made from an integrated circuit, wherein the interposer comprises a semiconductor die as described here above.

In a multilayer structure according to invention, the substrate of the semiconductor die can have a high resistivity which is more than 10 Ω.m In this case, the inner metallic conductor of the semiconductor die is for example connected to a signal and in that the surrounding conductive area of the semiconductor die is connected to the ground. The semiconductor die is then used in a co-axial configuration.

For a use in a tri-axial configuration, the substrate of the semiconductor die has preferably a low resistivity which is less than 10⁻³ Ω.m. In this case, the inner metallic conductor of the semiconductor die can be connected to a signal; the bulk material can be connected to the ground and the surrounding conductive area of the semiconductor die can be connected to a same voltage than the signal.

The invention also concerns a manufacturing process for manufacturing a semiconductor die as described here above. A manufacturing process according to the invention comprises the steps of:
- providing a p-doped silicon substrate,
- etching a hole in the silicon substrate from a first side of the substrate, the hole having at least a circumferential lateral wall,
- forming by a diffusion process a doped layer on the surface of the circumferential lateral wall so that the doping specie of the doped layer is the opposite type of the doping specie of the substrate,
- coating the doped layer with a dielectric layer,
- depositing a polysilicon layer on the first dielectric layer,
- depositing a second dielectric layer on the polysilicon layer, and
- coating the inner wall of the hole with a metallic layer,
wherein the surface of the circumferential lateral wall is doped with phosphorus, the concentration of dopants being more than 10¹⁵ atoms per cubic centimetre (>E15 a.cm⁻³) and the doping comprises the steps of:
- deposition of a phosphorus glass on the inner circumferential lateral surface of the hole by a low pressure chemical vapour deposition process,
- thermal treatment in an oven so that the dopant is driven into the substrate and activated, and
- removing the glass, after the thermal treatment, by etching using diluted hydrofluoric acid.

In a first embodiment of the process, the etched hole has a bottom and a further step of the process includes a grinding operation in which the substrate is ground from a side opposite to the first side of the substrate until the bottom so that the hole in the substrate becomes a through silicon via.

The dielectric layers are for example made of materials chosen in the set of materials containing silicon oxide, silicon nitride, silicon oxycarbide and polymers.

A manufacturing process according to the invention advantageously also comprises a step of providing a barrier layer between the metallic layer and the second dielectric layer to avoid the diffusion of the metal into the second dielectric layer.

An advantageous embodiment of a process according to the invention foresees that during the etching of the hole, in a same step, trenches are etched. In this way, the trenches are realised in only one step with the hole and thereafter the corresponding capacities (or any other 3D passive component like for example isolation trenches, 3D diodes ...) can also be manufactured during the steps used for the realisation of the through silicon via. The hole and the trenches are preferably realised by Reactive Ion Etching (RIE). With a such process, it is possible to realise holes and trenches with a high aspect ratio (i.e. ratio between the depth of the hole or the trench and its diameter or width.

The invention will now be described in more details by way of an example with reference to the accompanying drawings, in which:
Figures 1 to 24 show each a step from a process to realise a semiconductor die according the present invention, and
Figure 25 shows an embodiment of a semiconductor die according to the present invention.

Skilled persons in the art appreciate that elements in the figures are illustrated for simplicity and clarity and have not necessarily been drawn up to scale. For example, the dimensions of some of the elements in the figures may be exaggerated relative to other elements to help improve the understanding of the embodiments of the present invention. The numeral indications are only given as an example and are not limitative.

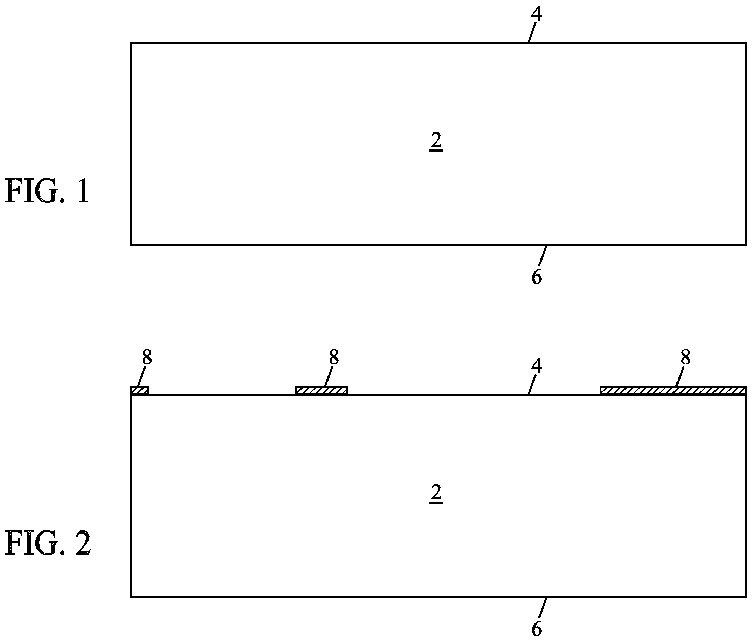

Figure 1 show a blank doped silicon substrate 2. This substrate 2 comes from a wafer of doped p-type silicon. It has a first side and a second side. In the following description, it will be considered that the substrate is oriented horizontally and that the first side is the upper side 4 of the substrate 2, the second side of the substrate 2 being the lower side 6.

In the step illustrated by figure 2, a nitride layer 8 is deposited, for example by a PECVD process and then patterned by combination of a lithography followed by an etch process step. This nitride layer 8 covers partially the upper side 4 of the substrate 2. It is a protective layer for a further step of the process.

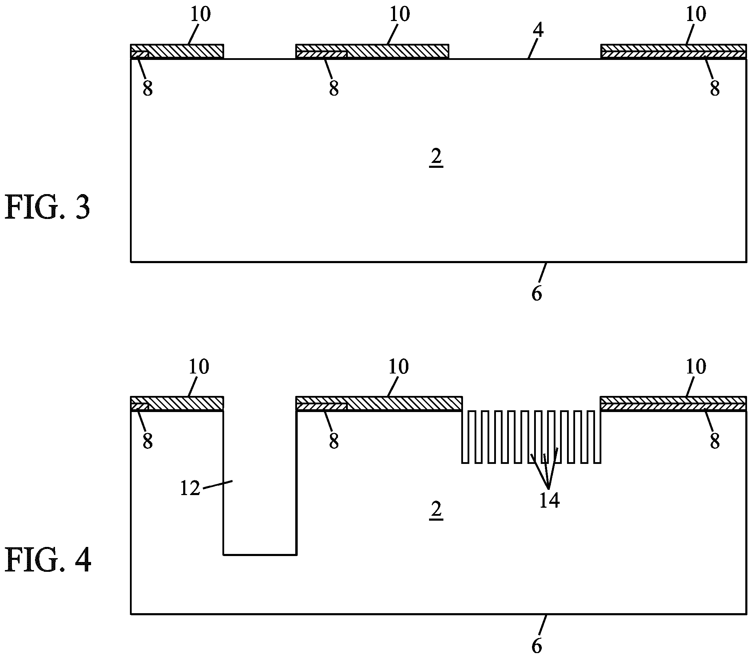

In the step corresponding to figure 3, a hard mask oxide layer 10 is deposited on the upper side 4 of the substrate 2 and covers the entire nitride layer 8 and also an area around the nitride layer 8. This oxide layer 10 is preferably deposited by a PECVD process and then patterned by combination of a lithography followed by an etch process step.

The next step (figure 4) is a deep silicon etching step. The etching process is made from the upper face. On the link side of figure 4, a deep hole 12 is etched. The etch step is for example a dry etch step, such as RIE (Reactive Ion Etching) or Bosch process, which is a RIE process with passivation and depassivation steps. The RIE process is used to obtain an anisotropic etch and allows therefore obtaining a high aspect ration (i.e. the ration between the depth of the hole and the diameter of the hole) which can be more than 20 or also more than 25. The depth of the hole 12 is a little less than the thickness (i.e. the distance between the upper face 4 and the lower face 6) of the substrate.

In the same step (see the right side of figure 4) deep trenches 14 can also be etched. The trenches 14 have also a high aspect ratio but are less deep than the hole 12 because their width is less than the diameter of the hole 12.

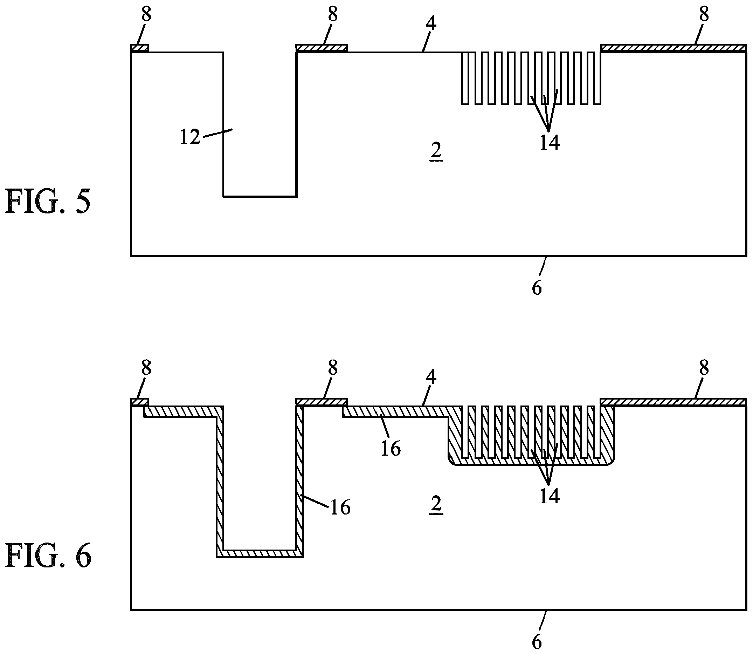

Once the etch step is achieved, the hard mask oxide 10 can be removed (figure 5) but the nitride layer 8 is kept. This layer is used as a mask for a further deposition step. From the upper side of the substrate 2, a conductive layer is formed by diffusion on the free surfaces (figure 6), i.e. the area of the upper side 4 which is not covered by the nitride layer 8, the lateral surface and the bottom of the hole 12 and the trenches 14. The conductive layer is an n-doped layer and notably, a phosphorus doped layer 16. This phosphorus doped layer (phosphorus glass) is deposited directly on the substrate 2. This step can be for example achieved by a chemical vapour deposition process. In a preferred embodiment of the invention, this layer can be deposited by a LPCVD process (Low-Pressure Chemical Vapour Deposition). After a thermal diffusion, a phosphorus doped layer 16 is formed into the substrate 2. Since this layer is n-doped and the substrate is p-doped, a diode is realised, namely around the hole 12 at the junction between the n-doped and the p-doped areas. After the thermal treatment and the simultaneous diffusion of dopants from the phosphorus glass to the substrate, the phosphorus glass layer can be removed by etching.

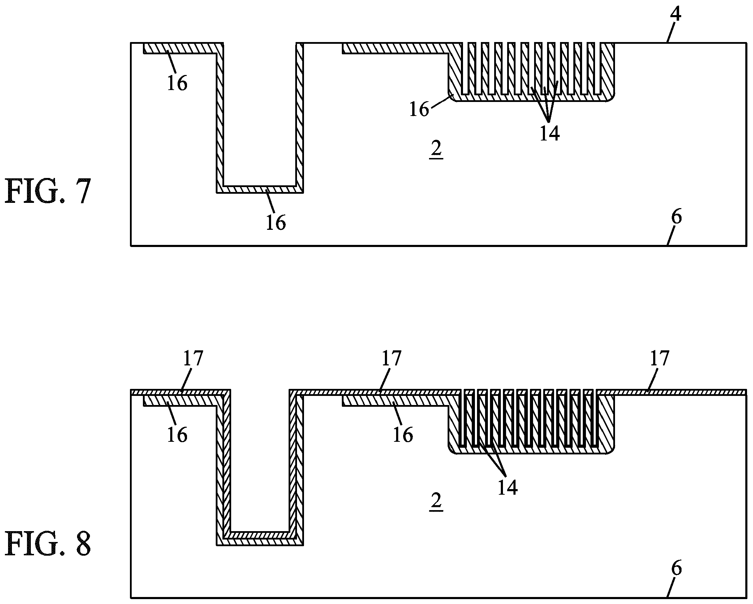

The next step (figure 7) proposed by the invention in the present process is the removal of the nitride layer 8. The upper side of the die corresponds again to the originally upper side 4 of the substrate 2.

Figure 8 illustrates a deposition of a dielectric layer 17 which covers all the die, i.e. the upper side 4 of the substrate 2, the walls of the hole 12 (lateral wall and bottom) and also the walls of the trenches 14.

This dielectric layer 17 is for example an Oxide Nitride Oxide (ONO) or silicon oxide (SiO₂). It covers the conductive layer (phosphorus doped layer 16) in the hole 12 and in the trenches 14.

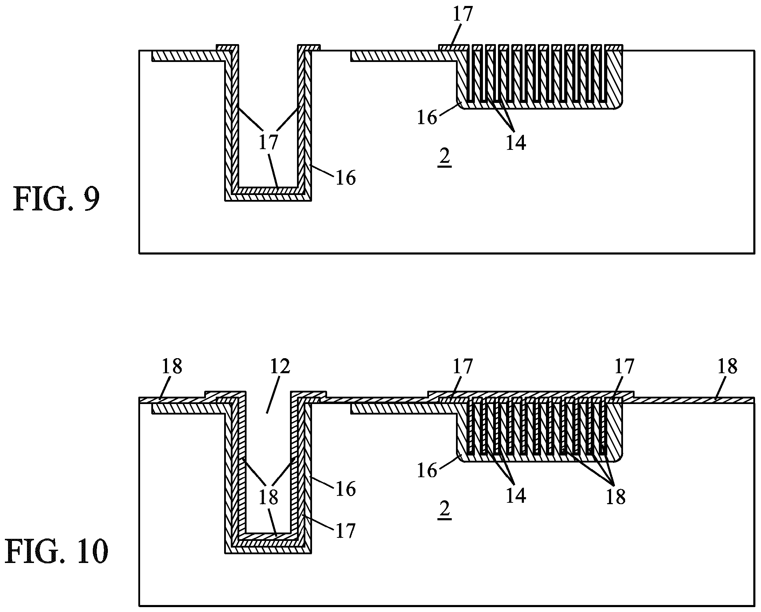

By way of lithography with a film resist, a part of the dielectric layer corresponding to the hole 12 and to the trenches 14 is protected and the rest of this dielectric layer 17 is removed by etching. In this way, the phosphorus doped layer 16 (conductive) is covered with the dielectric layer 17 in the hole 12 and in the trenches 14 (figure 9).

The next step (figure 10) proposed in the embodiment of the invention illustrated by the drawings is a deposition of a polysilicon layer 18 which covers all the die. This polysilicon layer covers also the still free upper side of the substrate 2, the lateral walls and the bottom of the hole 12, and also the dielectric layer 17 inclusive over the walls of the trenches 14.

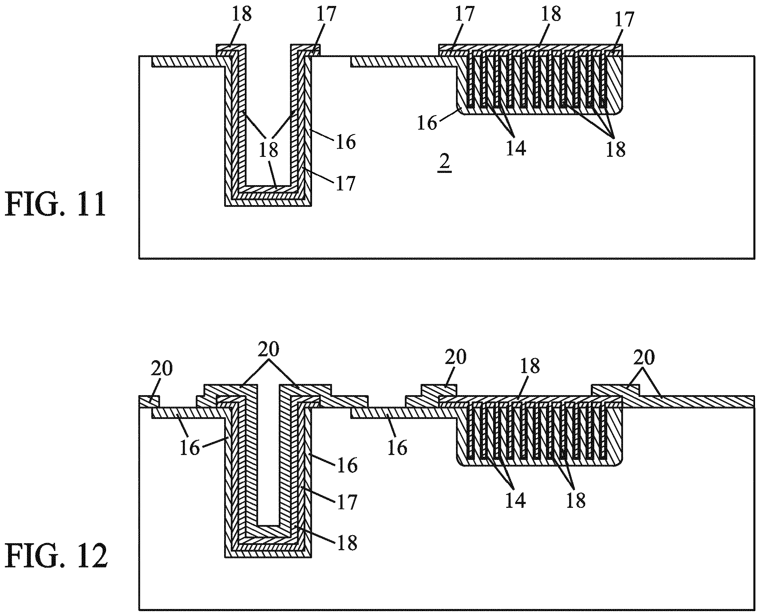

By way of lithography with a film resist, a part of the polysilicon layer 18 corresponding to the hole 12 and to the trenches 14 is protected and the rest of the polysilicon layer 18 is removed by etching (figure 11). In this way, the phosphorus doped layer 16 (conductive) is covered with the dielectric layer 17 and together with the polysilicon layer 18 in the area from the hole 12 and from the trenches 14.

The next step is a deposition, lithography (with film resist) and etching step. As a result of this step (figure 12), an oxide layer 20 allows to do the contact in the area of the trenches 14 and makes an insulation in the area of the hole 12. The deposition of the oxide (silicon oxide) can be made by LPCVD or by thermal oxidation. These processes give a good uniformity for the oxide layer 20. After deposition, a part of the oxide layer is protected by a film and the remaining part of the layer is etched.

The thickness of the dielectric layer can for example be comprised between 40 nm and 1 µm. It depends from the used deposition technique. This dielectric layer comprises the oxide layer 20 and the optional dielectric layer 17. This last layer can be omitted for example if no trenches are realized nearby the vias.

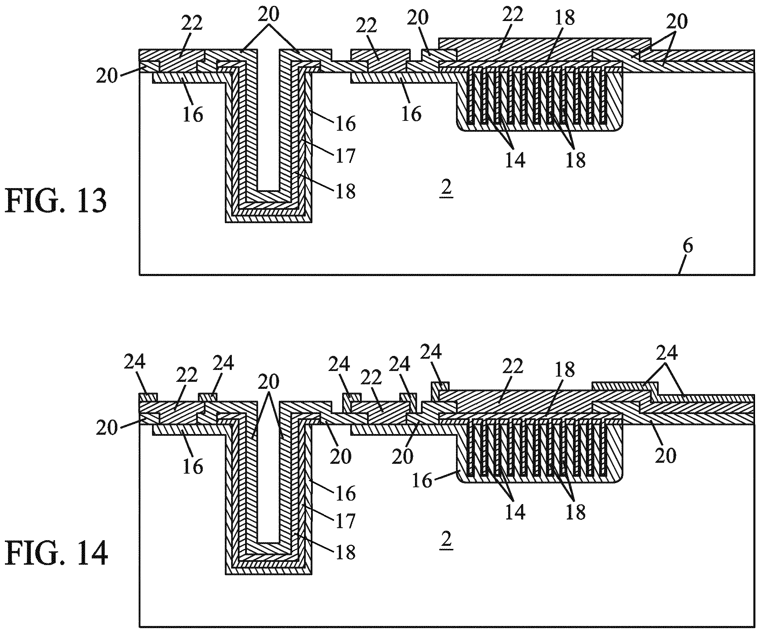

In the same way, the die is partially covered with an aluminium -or any other metal-layer 22 (figure 13) and thereafter with a second oxide layer 24 (figure 14). The deposition of the second oxide is for example made by PECVD (Plasma Enhanced Chemical Vapour Deposition). The second oxide layer 24 extends the first oxide layer 20 and has the same function than this first oxide layer 20

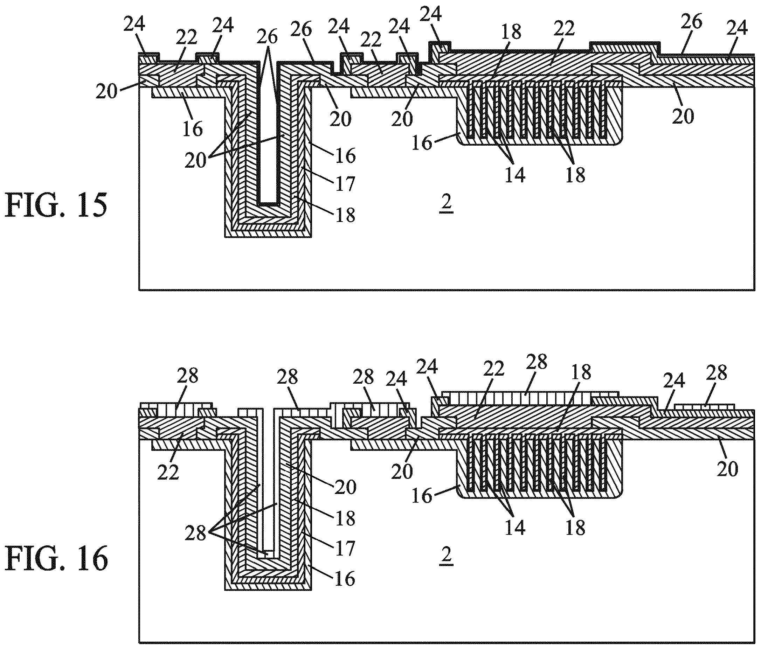

Figure 15 illustrates the installation of a barrier and seed layer 26. High temperature techniques, such as for example MOCVD or PVD or CVD (Chemical Vapour Deposition) or ALD (Atomic Layer Deposition), can be used for the deposition of the barrier. The seed layer can be set up by PVD for example. Titanium (Ti), titanium nitride (TiN), tantalum (Ta), tantalum nitride (TaN), ruthenium (Ru) or other materials can be used here.

The next step (figure 16) comprises a first 3D lithography phase using for example a negative resist or a resist film. So by the following phase of copper electroplating, targeted deposition of copper is realised. Copper 28 at least covers the wall (lateral wall and bottom) of the hole 12 and also forms contacts for the structure realised in the hole and in the trenches 14. The copper layer is preferably a thick layer having a thickness of at least 3 µm. In an alternative embodiment, this layer (copper 28) can completely fill the hole 12.

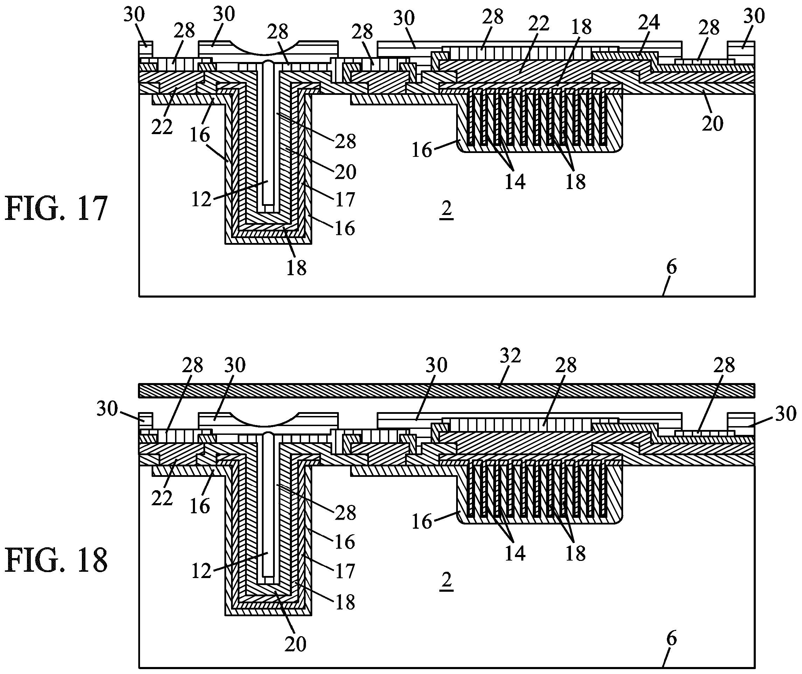

In the next step (figure 17), the invention proposes a passivation coating, for example an organic passivation. This step can also eventually provide a complete hole filling. This step uses also lithography and realises a surface passivation 30 in particular over the hole 12 and the trenches 14.

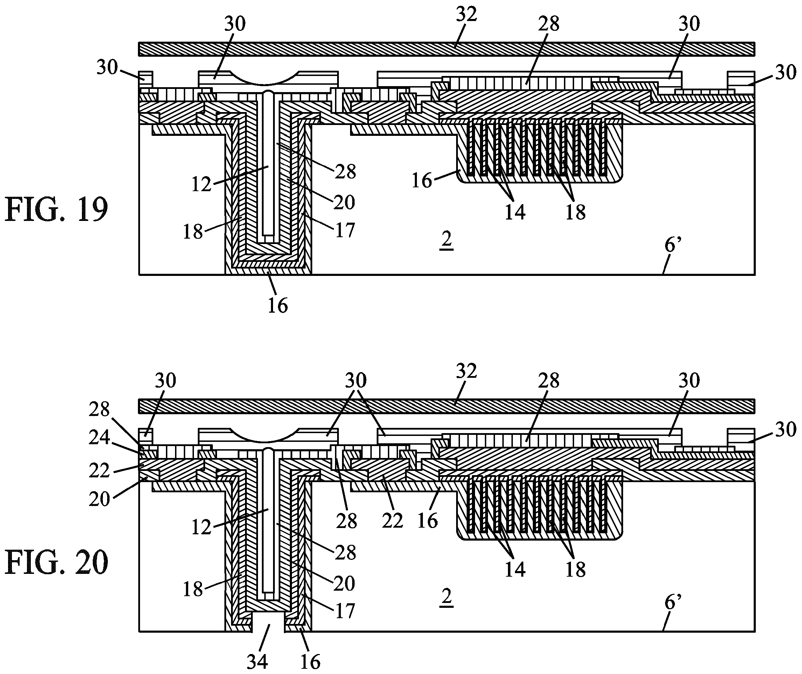

Following step (figure 18) is a preparation step in which the die is bonded on a glass substrate 32. So the die can be held for a thinning step (figure 19), for example by grinding, on the lower side 6 of the substrate 2. This last is thinned (grinded) in view of transforming the hole in a through silicon via (TSV). The thickness of the substrate 2 is reduced during this step so that the phosphorous doped layer 16 appears and a new lower side 6', which is flush with the phosphorous doped layer 16, is formed on the die.

Thereafter, an etching step is driven from the lower side of the die in the direction of the hole 12. Eventually silicon but essentially the phosphorous doped layer 16 and the dielectric layer 17 are etched and a cavity 34 is formed. The cavity 34 is preferably co-axial with the hole 12. At the bottom of the cavity 34, the oxide layer 20 appears. This layer is used as stopping layer for the etching of the cavity 34.

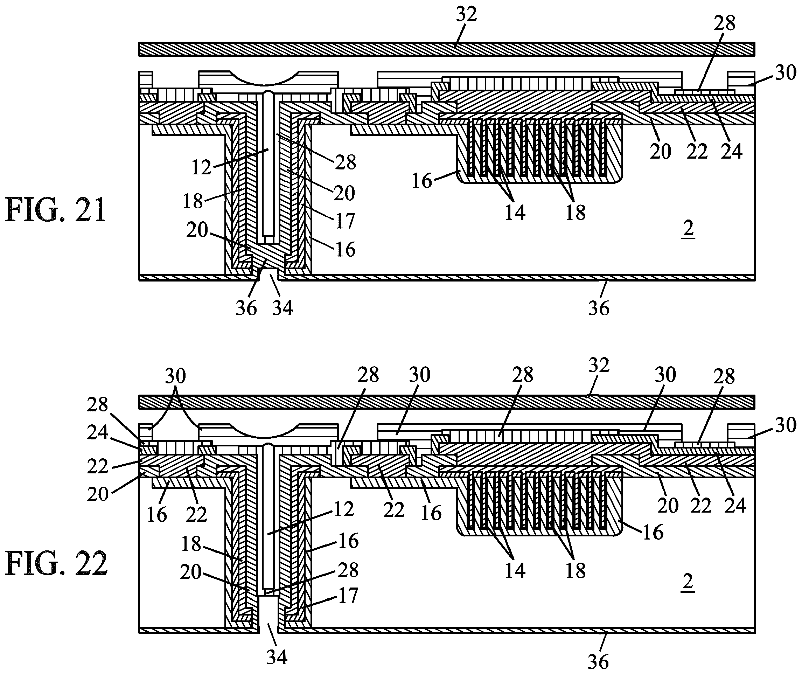

The lower side of the die is then covered, totally or at least above the cavity 34 and around it, by a new oxide layer 36 of the same kind than the oxide layer 20. In this embodiment, the oxide layer 36 is then for example a silicon oxide layer. In the process illustrated on the figures and namely on figure 21, the entire lower side of the die is covered with the silicon oxide layer. 36.

In order to realise a through silicon via, the copper 28 has to be accessible also from the lower side of the die. To this end, the oxide layer 36 and the oxide layer 20 are locally removed between the cavity 34 and the copper 28 in the hole 12 (figure 22). This can be done for example by contact etching, the barrier layer (copper 28) being used as a contact etch stop layer (CESL).

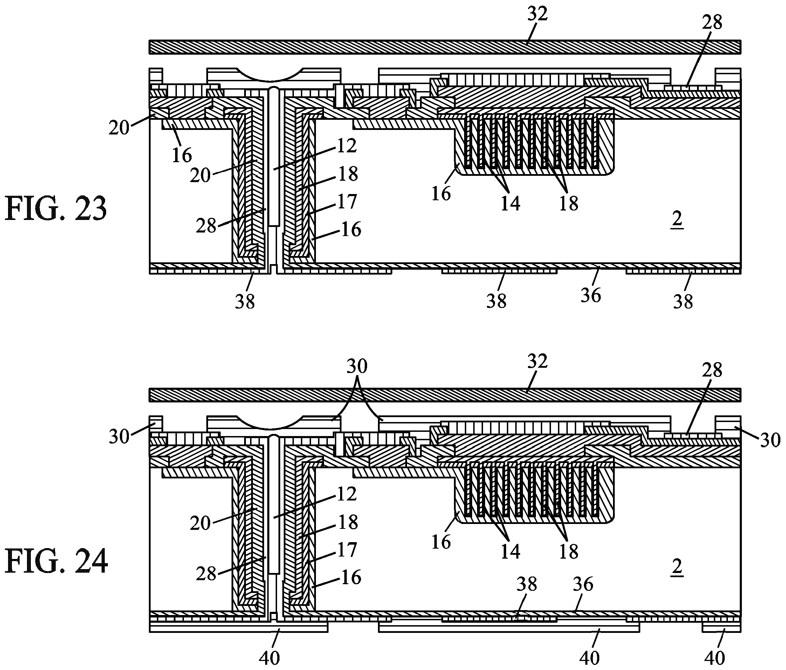

To make the access to the copper 28 easier from the lower side of the die, this lower side is metallised by deposition of a metallic layer 38, for example a layer of copper or of aluminium (figure 23). The deposition can be made by for example by PVD and then patterned by lithography and etching.

The metallic layer 38 is then passivated with an organic material, for example by lithography (figure 24). The metallic layer 38 is then partially covered by an organic material layer 40 (a mineral material could also be used here). At the end of the process, the obtained die is removed from its glass substrate 32.

As it will clearly appear to the person having ordinary skill in the art, additional interconnection levels can be built up by repeating the same process sequence.

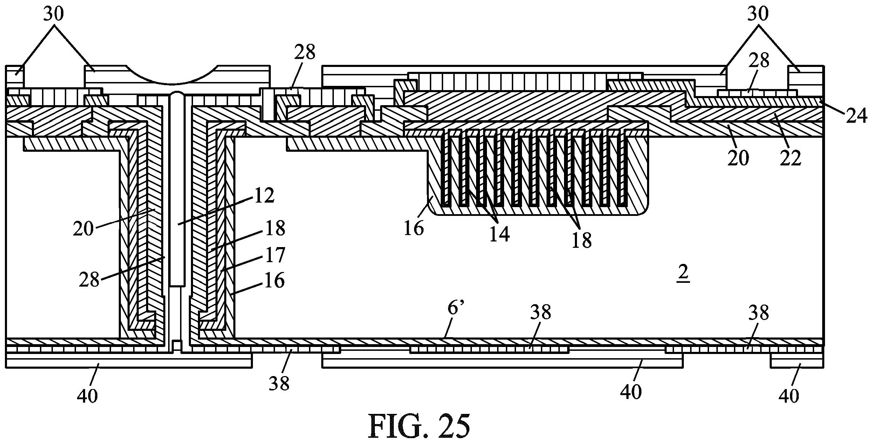

Figure 25 shows the die realised by the process described here before. This die comprises a through silicon via (TSV) which can be used to form a co-axial or a tri-axial TSV. Around the hole 12, there is a layer of copper 28 which is conductive. The copper is isolated from another conductive layer, the phosphorous doped layer 16, by a via insulation comprising an oxide layer 20 and a dielectric layer 17. The oxide layer 20 prevents the diffusion of the copper 28.

The phosphorus doped layer 16 is a n-type doped layer. It is surrounded by a p-type doped substrate 2 and forms with this substrate a diode.

This new structure allows first a direct current insulation from the via with the surrounding substrate. The oxide layer 20 and the dielectric layer 17 allow such insulation. It also allows a reduction of the coupling between the TSV and the surrounding material for alternative currents (AC), for example RF (Radio Frequency) currents. The diode around the via can be polarised. So its capacity is variable and can be adapted to the frequency of the current traversing the TSV.

If the TSV is used for co-axial application, the substrate will preferably have a high resistivity, for example more than 1 kΩ.cm (i.e. 10 Ω.m). If the TSV is used for tri-axial application, the substrate will preferably have a low resistivity, which can be lower than 100 mΩ.cm, for example 30 mΩ.cm (i.e. 3.10⁻⁴ Ω.m).

The TSV extends from the upper side of the die to its lower side. Its diameter is for example comprised between 40 µm and 150 µm (1 µm=10⁻⁶ m) and the aspect ratio of this hole (i.e. the ratio between its depth -or the thickness of the substrate after thinning- and its diameter) is for example comprised between 1 and 30. The hole outer contour can have any shape: circular, rounded, polygonal... the circular or rounded shape being the preferred shapes.

The doped layer, corresponding in the description of the phosphorous doped layer 16, in the finished die extends all around the hole, from the upper side of the silicon substrate to its lower side. It forms in this way a barrier between the hole and the substrate and is acting as a first shielding conductive layer in case of a co-axial or tri-axial application. The substrate is a p-doped substrate and the doped layer is a n-doped layer.

For the doped layer around the hole and in contact with the substrate, the doping species is phosphorus. The concentration of dopants in the doped layer is more than 10¹⁵ (E15 a.cm⁻³).

In this way, the TSV is surrounded by a conductive area obtained by diffusion of an opposite type dopant species compared to the substrate. In this way, a PN junction is formed over all the height of the TSV between the TSV and the substrate. This junction is a tubular junction shielding the TSV and which can be polarised, the cathode being the conductive layer and the anode the substrate.

The described structure allows obtaining a co-axial configuration by connecting
- the inner conductive layer (copper 28) to a signal, and
- the first shielding layer (diffused), i.e. the phosphorus doped layer 16, to the ground.

In this configuration (co-axial), the bulk substrate can be left floating or can be also connected to the ground.

By connecting
- the inner conductive layer (copper 28) to a signal,
- the conductive layer (phosphorus doped layer 16) to the same voltage than the signal -by using for example a buffering amplifier having a gain of 1- and
- the substrate 2 to the ground,

one can also obtain a tri-axial configuration. Since the bulk substrate is connected to the ground, the tubular diode is blocked in reverse mode and isolates in this way electrically the first shielding layer (diffused) from the substrate.

The tri-axial TSV has advantageous electrical properties. It allows EMI (ElectroMagnetic Interference) shielding, parasitic capacitance reduction and impedance adaptation. Since the tubular diode can be polarised, the impedance of this diode can be adapted while for prior art tri-axial TSV the insulation is realised by an oxide layer which has a constant voltage capacity. By adapting the impedance, it is possible to limit the reflection of a signal at an end of the TSV and to improve the transmission of the signal.

This tri-axial structure for a TSV is advantageous in comparison with a prior art structure having two metallic layers because one isolating layer is missing. The tubular diode acts as an isolating layer.

The described tubular diode can also be used as a separate component from the TSV. In this case, a high integration density can be obtained.

This tubular diode also offers a superior junction surface ratio compared to footprint.

Although embodiments of the present disclosure have been described in detail, those skilled in the art should understand that they may make various changes, substitutions and alterations herein within the scope of the following claims.

## Claims

1. A semiconductor die comprising a via realised in a bulk material (2), the via having an inner metallic conductor (28) isolated from a surrounding conductive area (16) by a first dielectric layer (17) and a second dielectric layer (20),
wherein the bulk material (2) is chosen in a set of doped semiconductor materials containing p-type materials,
wherein the surrounding conductive area (16) is in contact with the bulk material (2),
wherein the surrounding conductive area (16) is made from a material chosen in a set of doped semiconductor materials containing n-type materials,
wherein the surrounding conductive area (16) is formed by a diffused doped layer, the bulk material (2) is doped silicon and the surrounding conductive area (16) is doped with phosphorus, the concentration of dopants being more than 10¹⁵ atoms per cubic centimetre (>E15 a.cm⁻³). and
wherein the semiconductor die further comprises a third conductive layer formed by a polysilicon layer (18), this polysilicon layer (18) is between the inner metallic conductor (28) and the conductive area (16), and the polysilicon layer (18) is isolated from the conductive area (16) by the first dielectric layer (17) and from the inner metallic conductor by the second dielectric layer (20).

2. A semiconductor die according to claim 1, wherein the second dielectric layer (20) between the inner metallic conductor (28) and the polysilicon layer (18) is an oxide layer.

3. A semiconductor die according to claim 1 or 2, wherein it comprises at least one trench (14) capacity, and in that each trench capacity (14) comprises a conductive layer (16) having the same characteristics as the surrounding conductive area (16) and a polysilicon layer (18) having the same characteristics as the polysilicon layer (18) between the first dielectric layer (17) and the second dielectric layer (20).

4. A semiconductor die according to any of claims 1 to 3, wherein the via has an aspect ratio greater than 20 and preferably greater than 25.

5. Multilayer structure in which dies are stacked and comprising an interposer made from an integrated circuit, wherein the interposer comprises a semiconductor die according to any of claims 1 to 4.

6. Multilayer structure according to claim 5, wherein the substrate of the semiconductor die has a high resistivity which is more than 10 Ω.m

7. Multilayer structure according to claim 6, wherein the inner metallic conductor (28) of the semiconductor die is connected to a signal and in that the surrounding conductive area (16) of the semiconductor die is connected to the ground.

8. Multilayer structure according to claim 5, wherein the substrate of the semiconductor die has a low resistivity which is less than 10⁻³ Ω.m and in that the inner metallic conductor (28) of the semiconductor die is connected to a signal, in that the bulk material (2) is connected to the ground and in that the surrounding conductive area (16) of the semiconductor die is connected to a same voltage than the signal.

9. A manufacturing process for manufacturing a semiconductor die according to any of claims 1 to 4, comprising the steps of:
- providing a p-doped silicon substrate (2),
- etching a hole (12) in the silicon substrate (2) from a first side of the substrate, the hole (12) having at least a circumferential lateral wall,
- forming by a diffusion process a doped layer (16) on the surface of the circumferential lateral wall so that the doping species of the doped layer is the opposite type of the doping species of the substrate (2),
- coating the doped layer (16) with a first dielectric layer (17),
- depositing a polysilicon layer (18) on the first dielectric layer (17),
- depositing a second dielectric layer (20) on the polysilicon layer (18), and
- coating the second dielectric layer in the hole (12) with a metallic layer (28), wherein the surface of the circumferential lateral wall is doped with phosphorus, the concentration of dopants being more than 10¹⁵ atoms per cubic centimetre (>E15 a.cm⁻³) and the doping comprises the steps of:
- deposition of a phosphorus glass on the inner circumferential lateral surface of the hole by a low pressure chemical vapour deposition process,
- thermal treatment in an oven so that the dopant is driven into the substrate and activated, and
removing the glass, after the thermal treatment, by etching using diluted hydrofluoric acid.

10. A manufacturing process according to claim 9, wherein the etched hole (12) has a bottom and in that a further step includes a grinding operation in which the substrate (2) is ground from a side (6) opposite to the first side (4) of the substrate (2) until the bottom so that the hole (12) in the substrate becomes a through silicon via.

11. A manufacturing process according to claim 9 or claim 10, wherein the dielectric layers (17, 20) are made of materials chosen in the set of materials containing silicon oxide, silicon nitride, silicon oxycarbide and polymers.

12. A manufacturing process according to any of claims 9 to 11, wherein it comprises a step of providing a barrier layer (26) between the metallic layer (28) and the second dielectric layer (20) to avoid the diffusion of the metal into the second dielectric layer.

13. A manufacturing process according to any of claims 9 to 12, wherein during the etching of the hole (12), in a same step, trenches (14) are etched and the hole (12) and the trenches (14) are realised by Reactive Ion Etching (RIE).

## Patentansprüche

1. Halbleiterchip, der eine Durchkontaktierung umfasst, die in einem Bulk-Material (2) ausgeführt ist, wobei die Durchkontaktierung einen inneren metallischen Leiter (28) aufweist, der von einem umgebenden leitfähigen Bereich (16) durch eine erste dielektrische Schicht (17) und eine zweite dielektrische Schicht (20) isoliert ist,
wobei das Bulk-Material (2) aus einer Menge von dotierten Halbleitermaterialien ausgewählt ist, die Materialien vom p-Typ enthält,
wobei der umgebende leitfähige Bereich (16) mit dem Bulk-Material (2) in Kontakt ist,
wobei der umgebende leitfähige Bereich (16) aus einem Material hergestellt ist, das aus einer Menge von dotierten Halbleitermaterialien ausgewählt ist, die Materialien vom n-Typ enthält,
wobei der umgebende leitfähige Bereich (16) aus einer diffundierten dotierten Schicht gebildet ist, wobei das Bulk-Material (2) dotiertes Silizium ist und der umgebende leitfähige Bereich (16) mit Phosphor dotiert ist, wobei die Konzentration von Dotierstoffen höher als 10¹⁵ Atome pro Kubikzentimeter (>E15 a.cm³) ist, und
wobei der Halbleiterchip ferner eine dritte leitfähige Schicht umfasst, die aus einer Polysiliziumschicht (18) gebildet ist, wobei diese Polysiliziumschicht (18) sich zwischen dem inneren metallischen Leiter (28) und dem leitfähigen Bereich (16) befindet und die Polysiliziumschicht (18) von dem leitfähigen Bereich (16) durch die erste dielektrische Schicht (17) und von dem inneren metallischen Leiter durch die zweite dielektrische Schicht (20) isoliert ist.

2. Halbleiterchip nach Anspruch 1, wobei die zweite dielektrische Schicht (20) zwischen dem inneren metallischen Leiter (28) und der Polysiliziumschicht (18) eine Oxidschicht ist.

3. Halbleiterchip nach Anspruch 1 oder 2, wobei er mindestens eine Grabenkapazität (14) umfasst und wobei jede Grabenkapazität (14) eine leitfähige Schicht (16), die die gleichen Eigenschaften wie der umgebende leitfähige Bereich (16) aufweist, und eine Polysiliziumschicht (18), die die gleichen Eigenschaften wie die Polysiliziumschicht (18) aufweist, zwischen der ersten dielektrischen Schicht (17) und der zweiten dielektrischen Schicht (20) umfasst.

4. Halbleiterchip nach einem der Ansprüche 1 bis 3, wobei die Durchkontaktierung ein Seitenverhältnis von größer als 20 und vorzugsweise von größer als 25 aufweist.

5. Mehrschichtstruktur, in der Chips gestapelt sind und die einen Interposer umfasst, der aus einer integrierten Schaltung gebildet ist, wobei der Interposer einen Halbleiterchip nach einem der Ansprüche 1 bis 4 umfasst.

6. Mehrschichtstruktur nach Anspruch 5, wobei das Substrat des Halbleiterchips einen hohen spezifischen Widerstand aufweist, der höher als 10 Ω.m ist.

7. Mehrschichtstruktur nach Anspruch 6, wobei der innere metallische Leiter (28) des Halbleiterchips mit einem Signal verbunden ist und wobei der umgebende leitfähige Bereich (16) des Halbleiterchips mit der Masse verbunden ist.

8. Mehrschichtstruktur nach Anspruch 5, wobei das Substrat des Halbleiterchips einen niedrigen spezifischen Widerstand aufweist, der niedriger als 10⁻³ Ω.m ist, und wobei der innere metallische Leiter (28) des Halbleiterchips mit einem Signal verbunden ist, wobei das Bulk-Material (2) mit der Masse verbunden ist und wobei der umgebende leitfähige Bereich (16) des Halbleiterchips mit einer gleichen Spannung verbunden ist wie das Signal.

9. Herstellungsverfahren zum Herstellen eines Halbleiterchips nach einem der Ansprüche 1 bis 4, umfassend die Schritte des:
- Bereitstellens eines p-dotierten Siliziumsubstrats (2),
- Ätzens eines Lochs (12) in dem Siliziumsubstrat (2) von einer ersten Seite des Substrats, wobei das Loch (12) mindestens eine umlaufende seitliche Wand aufweist,
- Bildens einer dotierten Schicht (16) auf der Oberfläche der umlaufenden seitlichen Wand durch einen Diffusionsprozess, derart dass die Dotierstoffspezies der dotierten Schicht vom der Dotierstoffspezies des Substrats (2) entgegengesetzten Typ ist,
- Beschichtens der dotierten Schicht (16) mit einer ersten dielektrischen Schicht (17),
- Abscheidens einer Polysiliziumschicht (18) auf der ersten dielektrischen Schicht (17),
- Abscheidens einer zweiten dielektrischen Schicht (20) auf der Polysiliziumschicht (18), und
- Beschichtens der zweiten dielektrischen Schicht in dem Loch (12) mit einer metallischen Schicht (28),
wobei die Oberfläche der umlaufenden seitlichen Wand mit Phosphor dotiert wird, wobei die Konzentration von Dotierstoffen höher als 10¹⁵ Atome pro Kubikzentimeter (>E15 a.cm⁻³) ist und das Dotieren die Schritte umfasst des:
- Abscheidens eines Phosphorglases auf der inneren umlaufenden seitlichen Oberfläche des Lochs durch einen chemischen Niederdruck-Dampfabscheidu ngsprozess,
- thermischen Behandelns in einem Ofen, derart dass der Dotierstoff in das Substrat getrieben und aktiviert wird, und
Entfernens des Glases nach der Wärmebehandlung durch Ätzen unter Verwendung von verdünnter Fluorwasserstoffsäure.

10. Herstellungsverfahren nach Anspruch 9, wobei das geätzte Loch (12) einen Boden aufweist und wobei ein weiterer Schritt einen Schleifvorgang umfasst, in dem das Substrat (2) von einer Seite (6), die der ersten Seite (4) des Substrats (2) entgegengesetzt ist, bis zum Boden geschleift wird, derart dass das Loch (12) in dem Substrat eine Durchkontaktierung durch Silizium wird.

11. Herstellungsverfahren nach Anspruch 9 oder Anspruch 10, wobei die dielektrischen Schichten (17, 20) aus Materialien hergestellt werden, die aus der Menge von Materialien ausgewählt werden, die Siliziumoxid, Siliziumnitrid, Siliziumoxycarbid und Polymere enthält.

12. Herstellungsverfahren nach einem der Ansprüche 9 bis 11, wobei es einen Schritt des Bereitstellens einer Sperrschicht (26) zwischen der metallischen Schicht (28) und der zweiten dielektrischen Schicht (20) umfasst, um die Diffusion des Metalls in die zweite dielektrische Schicht zu vermeiden.

13. Herstellungsverfahren nach einem der Ansprüche 9 bis 12, wobei während des Ätzens des Lochs (12) in einem selben Schritt Gräben (14) geätzt werden und das Loch (12) und die Gräben (14) durch reaktives lonenätzen (RIE) ausgeführt werden.

## Revendications

1. Puce semi-conductrice comprenant un trou de liaison réalisé dans un matériau en vrac (2), le trou de liaison ayant un conducteur métallique interne (28) isolé d'une zone conductrice (16) environnante par une première couche diélectrique (17) et une deuxième couche diélectrique (20),
dans laquelle le matériau en vrac (2) est choisi dans un ensemble de matériaux semi-conducteurs dopés contenant des matériaux de type p,
dans laquelle la zone conductrice (16) environnante est en contact avec le matériau en vrac (2),
dans laquelle la zone conductrice (16) environnante est réalisée à partir d'un matériau choisi dans un ensemble de matériaux semi-conducteurs dopés contenant des matériaux de type n,
dans laquelle la zone conductrice (16) environnante est formée par une couche dopée diffusée, le matériau en vrac (2) est le silicium dopé et la zone conductrice (16) environnante est dopée au phosphore, la concentration de dopants étant supérieure à 10¹⁵ atomes par centimètre cube (>E15 a.cm⁻³), et
dans laquelle la puce semi-conductrice comprend en outre une troisième couche conductrice formée par une couche de polysilicium (18), cette couche de polysilicium (18) se trouve entre le conducteur métallique interne (28) et la zone conductrice (16), et la couche de polysilicium (18) est isolée de la zone conductrice (16) par la première couche diélectrique (17) et du conducteur métallique interne par la deuxième couche diélectrique (20).

2. Puce semi-conductrice selon la revendication 1, dans laquelle la deuxième couche diélectrique (20) entre le conducteur métallique interne (28) et la couche de polysilicium (18) est une couche d'oxyde.

3. Puce semi-conductrice selon la revendication 1 ou 2, dans laquelle elle comprend au moins une capacité de tranchée (14), et dans laquelle chaque capacité de tranchée (14) comprend une couche conductrice (16) ayant les mêmes caractéristiques que la zone conductrice (16) environnante et une couche de polysilicium (18) ayant les mêmes caractéristiques que la couche de polysilicium (18) entre la première couche diélectrique (17) et la deuxième couche diélectrique (20).

4. Puce semi-conductrice selon l'une quelconque des revendications 1 à 3, dans laquelle le trou de liaison a un rapport d'aspect supérieur à 20 et de préférence supérieur à 25.

5. Structure multicouche dans laquelle des puces sont empilées et comprenant un interposeur réalisé à partir d'un circuit intégré, dans laquelle l'interposeur comprend une puce semi-conductrice selon l'une quelconque des revendications 1 à 4.

6. Structure multicouche selon la revendication 5, dans laquelle le substrat de la puce semi-conductrice a une résistivité élevée qui est supérieure à 10 Q.m.

7. Structure multicouche selon la revendication 6, dans laquelle le conducteur métallique interne (28) de la puce semi-conductrice est connecté à un signal, et dans laquelle la zone conductrice (16) environnante de la puce semi-conductrice est connectée à la terre.

8. Structure multicouche selon la revendication 5, dans laquelle le substrat de la puce semi-conductrice a une faible résistivité qui est inférieure à 10⁻³ Ω.m, et dans laquelle le conducteur métallique interne (28) de la puce semi-conductrice est connecté à un signal, dans laquelle le matériau en vrac (2) est connecté à la terre, et dans laquelle la zone conductrice (16) environnante de la puce semi-conductrice est connectée à une même tension que le signal.

9. Processus de fabrication pour fabriquer une puce semi-conductrice selon l'une quelconque des revendications 1 à 4, comprenant les étapes suivantes :
- la fourniture d'un substrat de silicium dopé p (2),
- la gravure d'un trou (12) dans le substrat de silicium (2) à partir d'un premier côté du substrat, le trou (12) ayant au moins une paroi latérale circonférentielle,
- la formation, par un processus de diffusion, d'une couche dopée (16) sur la surface de la paroi latérale circonférentielle, de sorte que l'espèce de dopage de la couche dopée soit du type opposé à l'espèce de dopage du substrat (2),
- le revêtement de la couche dopée (16) avec une première couche diélectrique (17),
- le dépôt d'une couche de polysilicium (18) sur la première couche diélectrique (17),
- le dépôt d'une deuxième couche diélectrique (20) sur la couche de polysilicium (18), et
- le revêtement de la deuxième couche diélectrique dans le trou (12) avec une couche métallique (28),
dans lequel la surface de la paroi latérale circonférentielle est dopée au phosphore, la concentration de dopants étant supérieure à 10¹⁵ atomes par centimètre cube (>E15 a.cm⁻³) et le dopage comprend les étapes suivantes :
- le dépôt d'un verre de phosphore sur la surface latérale circonférentielle intérieure du trou par un processus de dépôt chimique en phase vapeur à basse pression,
- le traitement thermique dans un four, de sorte que le dopant soit entraîné dans le substrat et activé, et
- l'élimination du verre, après le traitement thermique, par gravure en utilisant l'acide fluorhydrique dilué.

10. Processus de fabrication selon la revendication 9, dans lequel le trou (12) gravé a un fond et dans lequel une étape supplémentaire comporte une opération de meulage dans laquelle le substrat (2) est meulé à partir d'un côté (6) opposé au premier côté (4) du substrat (2) jusqu'au fond, de sorte que le trou (12) dans le substrat devienne un trou de liaison de silicium traversant.

11. Processus de fabrication selon la revendication 9 ou la revendication 10, dans lequel les couches diélectriques (17, 20) sont réalisées en matériaux choisis dans l'ensemble de matériaux contenant l'oxyde de silicium, le nitrure de silicium, l'oxycarbure de silicium et des polymères.

12. Processus de fabrication selon l'une quelconque des revendications 9 à 11, dans lequel il comprend une étape consistant à fournir une couche barrière (26) entre la couche métallique (28) et la deuxième couche diélectrique (20) pour éviter la diffusion du métal dans la deuxième couche diélectrique.

13. Processus de fabrication selon l'une quelconque des revendications 9 à 12, dans lequel, pendant la gravure du trou (12), dans une même étape, des tranchées (14) sont gravées et le trou (12) et les tranchées (14) sont réalisés par gravure ionique réactive (RIE).
